# FASCICULE DE BREVET EUROPEEN

(11) **EP 0 533 802 B1**
(45) Date de publication et mention de la délivrance du brevet: **01.12.1993**
(21) Numéro de dépôt: 91911645.9
(22) Date de dépôt: 06.06.1991
(51) Int. Cl.: G01R 31/34, G01R 31/12

(54) **EVALUATION DU VIEILLISSEMENT DES ISOLANTS**
BEWERTUNG DER ALTERUNG VON ISOLATOREN
INSULATOR AGING ASSESSMENT METHOD

(30) Priorité: 15.06.1990 FR 9007492
(43) Date de publication de la demande: 31.03.1993
(73) Titulaire: S.I.T.E.L.E.C. S.A.R.L., F-84140 Montfavet (FR)
(72) Inventeur: DEJEAN, Philippe, F-31400 Toulouse (FR); GOLDMAN, Max, F-91190 Gif-sur-Yvette (FR); HAUG, Robert, F-91400 Orsay (FR)
(74) Mandataire: Bugnon-Hays, Claudine
(86) Numéro de dépôt international: FR9100452
(87) Numéro de publication internationale: WO9119991

(56) Documents cités:
- DE-A- 3 526 149
- US-A- 4 156 846
- ANNUAL REPORT, CONF. ON ELECTRICAL INSULATION AND DIELECTRIC PHENOMENA, 18 October 1987, GAITHERTSBURG, MARYLAND, US, pages 13-44, R: BARTNIKAS: "NATURE OF PARTIAL DISCHARGES AND THEIR MEASUREMENT"
- C. MENGUY ET AL., "CONFERENCE INTERNATIONALE DES GRANDS RESEAUX ELECTRIQUES A HAUTE TENSION" 28 September 1988, PARIS, FR

## Description

L'invention concerne un procédé d'évaluation automatique sous tension alternative du vieillissement des isolations-masse des machines tournantes fonctionnant sous moyenne tension et pouvant être utilisé aussi bien quand la machine est en fonctionnement que lorsqu'elle est à l'arrêt. L'invention concerne également un dispositif d'évaluation automatique sous tension alternative du vieillissement des isolations-masse des machines tournantes fonctionnant sous moyenne tension lorsque la machine est en fonctionnement et un dispositif analogue d'évaluation du vieillissement des isolations-masse lorsque la machine est à l'arrêt.

D'une façon classique, les machines tournantes fonctionnant sous moyenne tension se composent de trois éléments principaux : un carcasse métallique généralement reliée à la terre, plusieurs enroulements de conducteurs terminés par des connexions électriques, et des matériaux isolants composant l'isolation entre les deux premiers éléments. Ces isolants reliés à la carcasse métallique elle-même reliée à la terre sont désignés dans la présente demande sous le terme d'isolation-masse.

Lors de l'utilisation de la machine, les isolations-masse se dégradent progressivement jusqu'à leur destruction pouvant se présenter sous la forme d'un percement de l'isolation-masse mettant la machine hors d'usage.

Or, il a été démontré que la durée de vie de l'isolation est prépondérante par rapport à la durée de vie de la machine comportant cette isolation.

On s'est vite aperçu que les raisons d'une détérioration de l'isolation-masse d'une machine n'étaient pas dues à une seule cause.

Classiquement, et d'une façon relativement empirique, les techniques les plus anciennes pour évaluer le vieillissement des isolants consistent à étudier la composante sinusoïdale fondamentale qui est en fait une caractéristique du courant qui traverse l'isolation-masse comme si celle-ci se comportait comme un condensateur. L'énergie qui est alors stockée dans l'isolation-masse est stockée d'une part sous forme capacitive mais aussi, puisque l'isolant n'est pas parfait, sous forme résistive. La mesure classiquement effectuée consiste à observer le paramètre tan δ, qui est une grandeur sans dimension correspondant au rapport, à une fréquence donnée du courant sinusoïdal alternatif, de la quantité d'énergie perdue dans l'isolant sous forme de chaleur sur la quantité d'énergie stockée dans l'isolant sous forme capacitive. Cette mesure est effectuée grâce à un pont de Shering. Ce paramètre ne constitue cependant qu'un facteur de qualité qui ne varie pas de façon significative avant la détérioration imminente de l'isolant et ne permet pas de localiser les défaillances. Il ne permet donc pas de prévoir et d'évaluer de façon fiable le vieillissement de l'isolation.

Les études menées sur le sujet ont ensuite permis de constater que le vieillissement de l'isolant était lié à l'apparition à l'intérieur ou en surface de l'isolant d'occlusions gazeuses, communément appelées vacuoles. On a constaté que ces vacuoles étaient le siège de l'apparition de décharges générant un courant impulsionnel. Ces impulsions de courant correspondent à de faibles réductions quasi instantanées de la capacité de l'isolation-masse. La demande de brevet EP-A-038 790, propose une méthode de détection d'une tenue électrique insuffisante de l'isolation de bobinages. La méthode décrite met en oeuvre un pont de mesure dans lequel les bobinages et la carcasse sont reliés pour mesurer la capacité et la résistance de l'isolation-masse. Ce pont, qui correspond à un pont de Shering est de plus équipé d'un dispositif de mesure à haute sélectivité de fréquence prédéterminée. Il permet de mesurer l'amplitude maximale de la composante constituant la queue des impulsions du courant dû aux décharges partielles dans l'isolation du bobinage. La méthode utilisée dans cette demande de brevet constitue une amélioration à la technique précédente mais ne peut prendre en compte que des impulsions de courant dont l'amplitude est la plus grande. Or, les études ont montré que ce n'était pas uniquement ce genre d'impulsions qui étaient nocives et donc, cette méthode ne propose pas un moyen d'évaluer complètement l'état du vieillissement de l'isolation-masse.

Outre le fait que le procédé décrit dans la demande de brevet EP-A-038 790 ne permet pas de discriminer les impulsions, elle ne peut être employée que sur une machine à l'arrêt.

Le document "Annual Report, Conf. on Electrical Insulation and Dielectric Phenomena, 18 Oct. 1987, GAITHERTSBURG, Maryland, US, pages 13 - 44 R. Bartinkas: "Nature of Partial Discharges and their Measurement" décrit une méthode de mesure de l'intensité du courant traversant les isolations dû aux décharges partielles mais ne prenant pas en compte les composantes fréquentielles de ces décharges, ni les caractéristiques du courant traversant les machines munies de ces isolants.

La présente invention a pour objet de proposer un procédé d'évaluation automatique sous tension alternative des isolations-masse des machines tournantes sous moyenne tension.

La présente invention a également pour objet de proposer des dispositifs pouvant être utilisés pour la mise en oeuvre du procédé pour l'évaluation sous tension alternative des isolations-masse des machines tournantes, à l'arrêt, ou en fonctionnement.

En particulier, l'objet de la présente invention est de fournir un procédé et des dispositifs permettant d'évaluer à long terme le vieillissement des isolations-masse de ces machines. En effet, si les procédés et les dispositifs de l'état de la technique prennent en compte pour l'évaluation du vieillissement d'un procédé, d'une part, la composante sinusoïdale du courant alternatif et d'autre part, la composante impulsionnelle, ils ne prennent jamais en compte la composante non linéaire du courant alternatif.

La demanderesse a constaté que le courant traversant l'isolation-masse soumise à une tension sinusoïdale, se décomposait en plusieurs composantes de caractéristiques distinctes ;
- la composante sinusoïdale fondamentale dont la fréquence est celle de la tension appliquée,
- la composante impulsionnelle, due aux décharges partielles dans la masse de l'isolation, ainsi qu'aux décharges à la surface de cette isolation. Cette composante impulsionnelle se compose d'impulsions de courant correspondant à de faibles réductions quasi-instantanées de la capacité de l'isolation et ayant différentes composantes fréquentielles dont la valeur varie en fonction de la conductivité superficielle de l'isolant subissant la décharge,
- la composante non linéaire du courant alternatif, dont les composantes fréquentielles se répartissent principalement entre la fréquence fondamentale et son harmonique 2. Cette composante non linaire est due à des phénomènes de conduction non linéaire, de migrations d'ions.

Le procédé d'évaluation automatique, sous tension alternative, du vieillissement des isolations-masse des machines tournantes sous moyenne tension consiste à mesurer à la fois :
- l'amplitude et la phase de la composante sinusoïdale fondamentale du courant traversant l'isolation, par rapport à la tension appliquée,
- les amplitudes et les fréquences caractéristiques de la composante impulsionnelle du courant traversant l'isolation dues aux décharges partielles,
- la fréquence et l'amplitude de la composante non linéaire du courant traversant l'isolation,
- puis à discriminer les impulsions, en fonction de leurs composantes fréquentielles, de leur amplitude et de la phase de la tension appliquée.

Selon une variante, le procédé d'évaluation automatique sous tension alternative du vieillissement des isolations-masse des machines tournantes sous moyenne tension est effectué lorsque la machine est à l'arrêt et consiste à appliquer une tension alternative donnée à l'isolation-masse, à annuler la composante sinusoïdale du courant traversant l'isolation grâce à un générateur de courant de compensation, de façon à connaître la phase, la fréquence et l'amplitude de la composante sinusoïdale, à associer une chaîne de mesures se composant d'un convertisseur analogique, numérique couplé à un calculateur réalisant une transformée de Fourier rapide du signal dans la bande de fréquence utile de façon à mesurer la fréquence, l'amplitude et la phase de la composante non linéaire, à mesurer la fréquence propre, l'amplitude de chaque impulsion et la phase de tension appliquée pour chaque impulsion grâce à un réseau de filtres passe-bande de fréquences différentes mises en forme avant d'être acquis par ladite chaîne de mesure numérique puis à discriminer selon leurs fréquences et la phase de la tension appliquée les impulsions grâce à un moyen informatique de calcul d'acquisition et de représentation des données.

Selon une variante préférentielle de l'invention, le procédé d'évaluation automatique sous tension alternative du vieillissement des isolations-masse des machines tournantes sous moyenne tension est effectué lorsque la machine est en fonctionnement. Le procédé préférentiel consiste à suivre l'évolution de la composante sinusoïdale à mesurer la fréquence, l'amplitude et la phase de la composante non linéaire grâce à une chaîne de mesure se composant d'un convertisseur analogique-numérique couplé à un calculateur réalisant une transformée de Fourier rapide du signal dans la bande de fréquence utilise, à mesurer la fréquence propre, l'amplitude et la phase de chaque impulsion par rapport à la tension appliquée sur l'une des phases grâce à l'utilisation de plusieurs filtres passe-bande de fréquences différentes mises en forme avant plusieurs acquis sur une chaîne de mesure numérique puis à discriminer selon les fréquences les impulsions grâce à un moyen informatique de calcul d'acquisition et de représentation des données.

Dans le cas où la machine est arrêtée à partir des valeurs d'amplitude et de phase de la composante sinusoïdale mesurée pour des tensions appliquées croissantes, on calcule la capacité et la résistance de l'isolation ainsi que la tan δ. Bien sûr, la connaissance de ces valeurs n'est pas suffisante pour savoir l'état de dégradation de l'isolation-masse.

Les informations contenues dans le spectre de la composante non-linéaire représentant les phénomènes de conduction ionique et en particulier la mesure de la composante fréquentielle sont essentielles pour la prédiction de la durée de vie résiduelle d'une isolation-masse et en conséquence d'une machine. La composante non-linéaire qui représente les phénomènes de conduction ionique limités par les interfaces entre les différentes couches de matériau composite formant l'isolation peut révéler que le champ électrique se trouve renforcé au point d'initier des dégradations irréversibles de l'isolation à ces interfaces et donc être un très bon indicateur de vieillissement.

En ce qui concerne la composante impulsionnelle, chaque impulsion est comptabilisée en fonction de trois valeurs caractéristiques : sa phase par rapport à la tension appliquée, son amplitude et sa fréquence propre.

La phase permet de repérer la tension appliquée à l'instant de la décharge. Elle permet aussi de discriminer les impulsions en fonction de leur type (décharge de surface sur les développantes, décharge dans des vacuoles incluses dans l'isolation...).

L'amplitude correspond à la charge apparente de la décharge. C'est le paramètre principalement retenu dans les mesures classiques des décharges partielles. Elle peut donc être considérée en tant que telle ou bien exprimée en terme d'énergie.

Un graphe pouvant être obtenu à partir du moyen d'acquisition et de calcul informatique utilisés, et présentant le nombre de décharges en fonction de la phase et de l'amplitude donne immédiatement une image exploitable des mesures effectuées.

La prise en compte de la fréquence propre des impulsions permet de distinguer les décharges de courte durée de celles dont la durée est plus importante. La durée d'une impulsion dépend de la conductivité des parois de la vacuole dans laquelle se produit la décharge. Si les parois sont dégradées alors la durée des impulsions agumente avec la conductivité. La mesure de la fréquence propre est donc un moyen de connaître l'état de dégradation des parois des vacuoles et d'estimer la concentration des produits de dégradation. Cette mesure est à relier aux mesures de la composante non-linéaire.

La présente invention concerne également un dispositif d'évaluation automatique sous tension alternative des isolations-masse d'une machine tournante sous moyenne tension pour la mise en oeuvre du procédé précédemment décrit, dispositif pouvant être utilisé lorsque la machine est à l'arrêt. L'invention concerne également un dispositif analogue pouvant être utilisé lorsque la machine est en fonctionnement.

Le dispositif d'évaluation automatique sous tension alternative des isolations-masse des machines tournantes sous moyenne tension à l'arrêt comprend :
- une alimentation alternative moyenne tension contrôlée en amplitude reliée par une inductance de découplage L et une capacité C exempte de décharges partielles à un transformateur d'intensité différentiel à trois enroulements,
- une source de courant contrôlé compensant exactement la composante sinusoïdale fondamentale du courant traversant l'isolation-masse reliée au transformateur différentiel,
- un réseau de filtres constitué d'un filtre à bandes étroites accordé sur la fréquence fondamentale permettant de déterminer le courant de compensation, d'un filtre passe-bas avec un amplificateur pour la mesure de la composante non-linéaire et de plusieurs filtres étant relié d'une part au transformateur différentiel et d'autre part à une chaîne de mesure comprenant un convertisseur analogique numérique couplé à un calculateur réalisant une transformée de Fourier rapide du signal dans la bande de fréquence utile couplée à un moyen de mesure et de discrimination des impulsions en fonction de leurs composantes fréquentielles, ladite chaîne de mesure étant contrôlée par un moyen informatique de calcul, d'acquisition et de représentation des mesures.

Le dispositif analogue d'évaluation automatique sous tension alternative des isolations-masse d'une machine tournante sous moyenne tension en fonctionnement comprend :
- trois inductances de découplage L et de trois capacités C exemptes de décharges partielles reliés d'une part à la source de courant alternatif et d'autre part à un transformateur d'intensité différentiel à quatre enroulements,
- un réseau de filtres constitué d'un filtre passe-bas avec un amplificateur pour la mesure des courants non impulsionnels (composante sinusoïdale et composante non-linéaire) et de plusieurs filtres passe-bande pour la discrimination des impulsions en fonction de leurs composantes fréquentielles, ce réseau de filtres étant relié d'une part au transformateur différentiel et d'autre part à une chaîne de mesures comprenant un convertisseur analogique-numérique et à un calculateur réalisant une transformée de Fourier rapide du signal dans la bande de fréquence utile couplée à un moyen de mesure et de discrimination des décharges partielles, ladite chaîne de mesure étant contrôlée par un moyen informatique calcul, d'acquisition et de représentation des mesures.

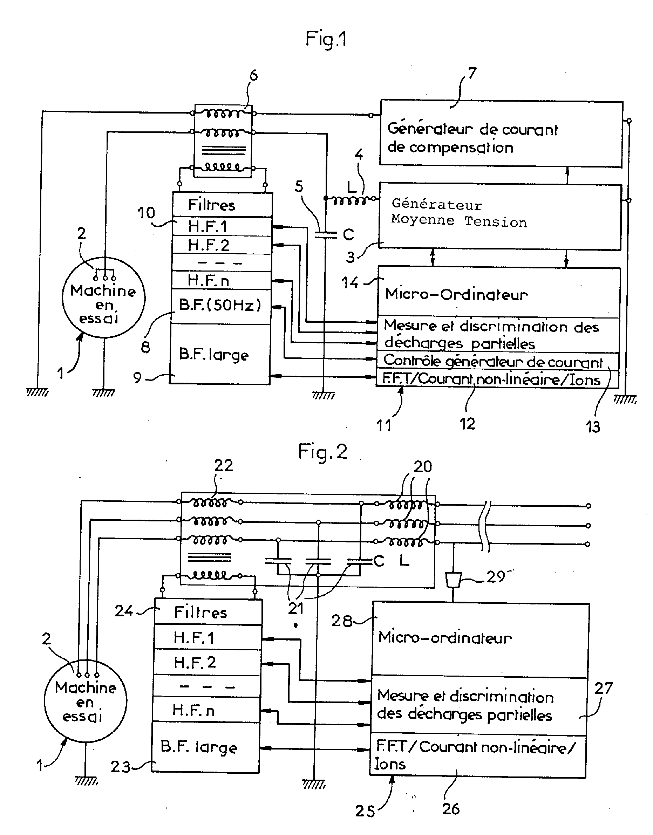

L'invention ainsi que les nombreux avantages qu'elle présente seront plus facilement compris grâce aux dessins dans lesquels la figure 1 représente le schéma fonctionnel d'un dispositif d'évaluation automatique sous tension alternative du vieillissement de l'isolation-masse d'une machine tournante sous moyenne tension à l'arrêt et la figure 2 représente un schéma fonctionnel d'un dispositif d'évaluation automatique sous tension alternative de l'isolation-masse d'une machine tournante sous moyenne tension en fonctionnement.

Selon la figure 1, une machine en essai 1, munie d'un bornier 2 est à l'arrêt. Cette machine 1 est reliée à un dispositif selon l'invention représentée schématiquement pour des raisons de compréhension. Ce dispositif est constitué d'une alimentation alternative moyenne tension contrôlée en amplitude, d'une inductance L de découplage 4, d'une capacité C exempte de décharge partielle 5, d'un transformateur d'intensité différentiel 6 à trois enroulements, d'une source de courant 7 contrôlé qui compense la composante sinusoïdale fondamentale du courant traversant l'isolation, d'un filtre à bandes étroites 8 accordé sur la fréquence fondamentale (50 hertz) permettant de déterminer le courant de compensation, d'un filtre passe-bas 9 muni d'un amplificateur pour la mesure de la composante non-linéaire, un réseau de plusieurs filtres passe-bande 10 pour la discrimination des impulsions, d'une chaîne de mesure 11 constituée d'un convertisseur analogique numérique couplé à un calculateur réalisant une transformée de Fourier rapide du signal dans la bande de fréquence utile 12, c'est-à-dire, 0 à 10 fois la fréquence de la source moyenne tension, d'un moyen de mesure et de discrimination des décharges partielles 13 et d'un moyen informatique 14 d'acquisition de calcul et de représentation des mesures constitué dans le présent exemple par un micro-ordinateur.

Le dispositif est relié aux connexions de la machine 1 à l'arrêt. Le transformateur différentiel 6 est relié au réseau de filtres 8, 9, 10 et à l'alimentation alternative 3 compensée par le générateur de courant 7 et au bornier 2. Une chaîne de mesure 11 est reliée directement au moyen 14 d'acquisition de calcul et de représentation des mesures et au réseau de filtres 8, 9, 10.

La figure 2 représente un dispositif d'évaluation du vieillissement de l'isolation-masse d'une machine en fonctionnement 1 constitué de trois inductances L de découplage 20, de trois capacités C exemptes de décharges partielles 21, d'un transformateur d'intensité différentielle à quatre enroulements 22, d'un filtre passe-bas 23 muni d'un amplificateur pour la mesure de la composante non-linéaire 23, de plusieurs filtres passe-bande pour la discrimination des impulsions 24, d'une sonde de mesure de la tension appliquée 29, d'une chaîne de mesure 25 constituée d'un convertisseur analogique-numérique couplé à un calculateur 26 réalisant une transformée de Fourier rapide du signal dans la bande fréquence utile (0 à 10 fois la fréquence d'un réseau), d'un moyen de mesure et de discrimination des décharges partielles 27 et d'un moyen 28 informatique d'acquisition de calcul et de représentation des mesures constitué par un micro ordinateur dans le cas du présent exemple.

Le dispositif est relié au bornier 2 de la machine 1 et la source de courant alternatif alimentant la machine 1 en fonctionnement. Le transformateur différentiel 22 est relié à cette source de courant par les trois inductances 20 et les trois capacités 21 et est par ailleurs relié au bornier 2 et au réseau de filtres 23, 24. Ce réseau de filtres est relié à la chaîne de mesure 25 qui est elle-même directement reliée au moyen informatique 28 d'acquisition, de calcul et de représentation des mesures.

## Revendications

1. Procédé d'évaluation automatique, sous tension alternative, du vieillissement des isolations-masse des machines tournantes sous moyenne-tension comprenant une étape consistant à mesurer les amplitudes de la composante impulsionnelle du courant traversant l'isolation, caractérisé en ce qu'il consiste à mesurer à la fois :
- l'amplitude et la phase de la composante sinusoïdale fondamentale du courant traversant l'isolation ;
- les fréquences et les amplitudes caractéristiques de la composante impulsionnelle du courant traversant l'isolation dû aux décharges partielles ;
- la fréquence et l'amplitude de la composante non-linéaire du courant traversant l'isolation ; puis à discriminer les impulsions en fonction de leurs composantes fréquentielles.

2. Procédé d'évaluation automatique sous tension alternative du vieillissement des isolations-masse des machines tournantes sous moyenne tension selon la revendication 1 caractérisé en ce qu'il est effectué lorsque la machine est à l'arrêt.

3. Procédé d'évaluation automatique sous tension alternative du vieillissement des isolations-masse des machines tournantes sous moyenne tension selon la revendication 2, caractérisé en ce qu'il consiste :
- à appliquer une tension alternative donnée à l'isolation-masse,
- à annuler la composante sinusoïdale du courant traversant l'isolation grâce à un générateur de courant de compensation, de façon à connaître la phase, la fréquence et l'amplitude de la composante sinusoïdale,
- à associer une chaîne de mesures se composant d'un convertisseur analogique-numérique couplé à un calculateur réalisant une transformée de Fourier rapide du signal dans la bande de fréquence utile de façon à mesurer les fréquences amplitudes et phases de la composante non linéaire,
- à mesurer la fréquence propre, l'amplitude de chaque impulsion et la phase de la tension appliquée pour chaque impulsion grâce à un réseau filtres passe-bande de fréquences différentes mises en forme avant d'être acquis par ladite chaîne de mesure numérique puis à discriminer les impulsions selon leurs fréquences, leurs amplitudes et la phase de tension appliquée grâce à un moyen informatique de calcul, d'acquisition et de représentation des données.

4. Procédé d'évaluation automatique sous tension alternative du vieillissement des isolations-masse des machines tournantes sous moyenne tension selon la revendication 1, caractérisé en ce qu'il est effectué lorsque la machine est en fonctionnement.

5. Procédé selon l'évaluation automatique sous tension alternative du vieillissement des isolations-masse selon la revendication 4, caractérisé en ce qu'il consiste à suivre l'évolution de la composante sinusoïdale à mesurer les fréquences, amplitudes et phases de la composante non linéaire grâce à une chaîne de mesure comprenant un convertisseur analogique-numérique couplé à un calculateur réalisant une transformée de Fourier rapide du signal dans la bande de fréquence utile, à mesurer la fréquence propre et l'amplitude de la phase de chaque impulsion par rapport à la tension appliquée sur l'une des phases grâce à l'utilisation de plusieurs filtres passe-bande de fréquences différentes mises en forme avant d'être acquis par une chaîne de mesure numérique puis à discriminer selon leurs fréquences les impulsions grâce à un moyen informatique de calcul, d'acquisition et de représentation des données.

6. Dispositif d'évaluation automatique sous tension alternative des isolations-masse d'une machine (1) tournante sous moyenne tension pour la mise en oeuvre du procédé selon les revendications 1 à 3, caractérisé en ce qu'il comprend :
- une alimentation alternative moyenne tension (3) contrôlée en amplitude reliée par une inductance de découplage L (4) et une capacité C (5) exempte de décharges partielles à un transformateur d'intensité différentiel (6) à trois enroulements,
- une source de courant contrôlé (7) compensant la composante sinusoïdale fondamentale du courant traversant lisolation-masse reliée au transformateur (6),
- un réseau filtres constitué d'un filtre à bandes étroites (8) accordé sur la fréquence fondamentale permettant de déterminer le courant de compensation, d'un filtre passe-bas (9) avec un amplificateur pour la mesure de la composante non-linéaire et de plusieurs filtres passe-bande (10) pour la discrimination des impulsions en fonction de leurs composantes fréquentielles, ce réseau de filtres étant relié d'une part au transformateur différentiel (6) et d'autre part à une chaîne de mesure (11) comportant un convertisseur analogique numérique couplé à un calculateur (12) réalisant une transformée de Fourier rapide du signal dans la bande de fréquence utile couplée à un moyen de mesure et de discrimination (13) des décharges partielles, ladite chaîne de mesure étant contrôlée par un moyen informatique (14) de calcul, d'acquisition et de représentation des mesures.

7. Dispositif d'évaluation automatique sous tension alternative des isolations-masse (2) d'une machine tournante (1) sous moyenne tension pour la mise en oeuvre du procédé selon l'une quelconque des revendications 1, 4 ou 5, caractérisé en ce qu'il comprend :
- trois inductances de découplage L (20) et trois capacités C (21) exemptes de décharges partielles reliées d'une part à la source de courant alternatif et d'autre part à un transformateur d'intensité différentiel (22) à quatre enroulements, une sonde de mesure de la tension appliquée (29),
- un réseau de filtres constitué d'un filtre passe-bas (22) avec un amplificateur pour la mesure des courants non impulsionnels (composante sinusoïdale et composante non-linéaire) et de plusieurs filtres passe-bande (24) pour la discrimination des impulsions en fonction de leurs composantes fréquentielles, ce réseau de filtres étant relié d'une part au transformateur différentiel (22) analogique-numérique couplé à un calculateur (26) réalisant une transformée de Fourier rapide du signal dans la bande de fréquence utile couplée à un moyen de mesure et de discrimination (27) des décharges partielles, ladite chaîne de mesure étant contrôlée par un moyen informatique (28) de calcul, d'acquisition et de représentation des mesures.

## Patentansprüche

1. Automatisches Einschätzungsverfahren der Isolationsmassen-Alterung von elektrischen Maschinen unter Mittelwechselspannung, das eine Etappe zur Amplitudenmessung der Impulskomponente des die Isolation durchquerenden Stroms einschließt, dadurch gekennzeichnet, daß es die gleichzeitige Messung enthält:
- der Amplitude und der Phase der Sinusgrundkomponente des die Isolation durchquerenden Stroms;
- der Frequenzen und der Kennamplituden der Impulskomponente des die Isolation bedingt durch Teilentladungen durchquerenden Stroms;
- der Frequenz und der Nichtlinarkomponenten-Amplitude des die Isolation durchquerenden Stroms;
dann die Unterscheidung der Impulsionen in Funktion ihrer Frequenzkomponenten.

2. Automatisches Einschätzungsverfahren der Isolationsmassen-Alterung von elektrischen Maschinen unter Mittelwechselspannung nach Patentanspruch 1, dadurch gekennzeichnet, daß es bei Maschinestopp vorgenommen wird.

3. Automatisches Einschätzungsverfahren der Isolationsmassen-Alterung von elektrischen Maschinen unter Mittelwechselspannung nach Patentanspruch 2, dadurch gekennzeichnet, daß es besteht aus:
- dem Anlegen einer gegebenen Wechselspannung an die Isolationsmasse,
- dem derartigen Aufheben dank eines Ausgleichstromgenerators der Sinuskomponente des die Isolation durchquerenden Stroms, um die Phase, die Amplitudenfrequenz der Sinuskomponente zu kennen,
- dem Assoziieren einer Meßkette, die besteht aus einem analognumerischen Wandler gekoppelt an einen Rechner, welcher eine schnelle Fourier-Transformation des Signals im nützlichen Frequenzbereich derart erstellt, daß die Amplitudenfrequenzen und Phasen der nicht-linearen Komponente gemessen werden,
- dem Messen der Eigenfrequenz, der Amplitude jeder Impulsion und der Phase der angelegten Spannung jeder Impulsion dank eines Bandfilternetzes verschiedener, vor dem Erfassen der gebildeten Frequenzen durch besagte numerische Meßkette, dann aus der Unterscheidung der Impulsionen nach ihren Frequenzen, ihren Amplituden und der angelegten Spannungsphase dank eines EDV-Mittels zum Rechnen, zur Erfassung und zur Datendarstellung.

4. Automatisches Einschätzungsverfahren der Isolationsmassen-Alterung von elektrischen Maschinen unter Mittelwechselspannung nach Patentanspruch 1, dadurch gekennzeichnet, daß es bei Maschinenbetrieb vorgenommen wird.

5. Verfahren entsprechend dem automatischen Einschätzungsverfahren der Isolationsmassen-Alterung von elektrischen Maschinen unter Wechselspannung nach Patentanspruch 4 dadurch gekennzeichnet, daß es aus der Verlaufsverfolgung der Sinuskomponente zum Messen der Frequenzen, Amplituden und Phasen der nicht-linearen Komponente besteht dank einer Meßkette mit einem analog-numerischen Wandler gekoppelt an einen Rechner, welcher eine schnelle Fourier-Transformation des Signals im nützlichen Frequenzbereich erstellt, daß die Eigenfrequenz und Phasenamplitude jeder Impulsion bezogen auf eine an die Phasen angelegte Spannung dank der Benutzung von mehreren Bandfiltern von verschiedenen, vor dem Erfassen durch besagte Kette von numerischer Messung geformten Frequenzen gemessen werden, dann aus der Unterscheidung der Impulsionen nach ihren Frequenzen dank eines EDV-Mittels zum Rechnen, zur Erfassung und zur Datendarstellung.

6. Automatische Einschätzungsvorrichtung der Isolationsmassen-Alterung einer elektrischen Maschine (1) unter Mittelwechselspannung zur Benutzung des Verfahrens gemäß der Patentansprüche 1 bis 3, dadurch gekennzeichnet, daß es einschließt:
- eine in der Amplitude kontrollierte Mittelwechsel-Spannungsversorgung (3), die über eine Induktivitätsabkopplung L (4) und ein von Teilentladungen freies C-Glied (5) an einen Differentialstromwandler (6) mit drei Wicklungen angeschlossen ist,
- eine kontrollierte Stromquelle (7) zum Ausgleichen der an den Transformator (6) angeschlossenen Sinusgrundkomponente des die Isolationsmasse durchquerenden Stroms,
- ein Filternetz aus einem Schmalbandfilter (8), der zur Bestimmung des Ausgleichstroms auf die Grundfrequenz abgestimmt ist, aus einem Tiefpaßfilter (9) mit einem Verstärker zur Messung der nicht-linearen Komponente und aus mehreren Tiefpaßfiltern (10) zur Unterscheidung der Impulsionen in Funktion ihrer Frequenzkomponenten, dabei ist dieses Filternetz einerseits an den Differentialstromwandler (6) und andererseits an eine Meßkette (11) angeschlossen, die einen an einen Rechner (12) gekoppelten analog-numerischen Wandler einschließt, welcher eine schnelle Fourier-Transformation des Signals im nützlichen Frequenzbereich erstellt, die an ein Meß- und Unterscheidungsmittel (13) der Teilentladungen gekoppelt ist, dabei wird die besagte Meßkette durch ein EDV-Mittel zum Rechnen, zur Erfassung und zur Datendarstellung (14) kontrolliert.

7. Automatische Einschätzungsvorrichtung der Isolationsmassen (2) einer elektrischen Maschine (1) unter Mittelwechselspannung zur Benutzung des Verfahrens entsprechend irgendeinem der Patentansprüche 1, 4 oder 5 dadurch gekennzeichnet, daß sie einschließt:
- drei Induktivitätsabkopplungen L (20) und drei von Teilentladungen freie C-Glieder (21), die einerseits an die Wechselstromquelle und andererseits an einen Differentialstromwandler (22) mit vier Wicklungen, einen Meßfühler der angelegten Spannung (29) angeschlossen sind,
- einem Filternetz bestehend aus einem Tiefpaßfilter (22) mit einem Verstärker zum Messen der impulsfreien Ströme (Sinus- und nicht-lineare Komponente) und aus mehreren Bandfiltern (24) zur Unterscheidung der Impulsionen in Funktion ihrer Frequenzkomponenten; dabei ist dieses Filternetz einerseits an den analog-numerischen Differentialstromwandler (22) angeschlossen und gekoppelt an einen Rechner (26), welcher eine schnelle Fourier-Transformation des Signals im nützlichen Frequenzbereich erstellt, gekoppelt an ein Meß- und Unterscheidungsmittel (27) der Teilentladungen, dabei wird die besagte Meßkette durch ein EDV-Mittel zum Rechnen, zur Erfassung und zur Datendarstellung (28) kontrolliert.

## Claims

1. An automatic evaluation process, under a.c. voltage, of the ageing of the insulation-mass of rotating machines under medium high voltage which comprises a stage consisting in measuring the amplitudes of the pulsatory component of the current which flows through the insulation, characterized in that it consists in measuring at the same time:
- the amplitude and the phase of the fundamental sinusoidal component of the current which flows through the insulation;
- the frequency and the amplitude characteristics of the pulstatory component of the current which flows through the insulation due to partial discharges;
- the frequency and the amplitude of the non-linear component of the current which flows through the insulation; then in distinguishing the pulses according to their frequency components.

2. An automatic evaluation method under a.c. voltage of the ageing of the insulation-mass of rotating machines under medium high voltage according to claim 1 characterized in that it is implemented when the machine is not running.

3. An automatic evaluation method under a.c. voltage of the ageing of insulation-mass of rotating machines under medium high voltage according to claim 2, characterized in that it consists in:
- applying a given a.c. voltage to the insulation-mass;
- cancelling the sinusoidal component of the current which flows through the insulation thanks to a compensating current generator so as to know the phase, the frequency and the amplitude of the sinusoidal component;
- associating a measuring chain including an analog to digital converter coupled with a calculator which performs a quick Fourier transform of the signal in the useful frequency band so as to measure the frequencies, amplitudes and phases of the non-linear component;
- measuring the natural frequency, the amplitude of each pulse and the phase of the applied voltage for each pulse thanks to a network of different shaped frequencies bandpass filters before being acquired by said digital measuring chain, then distinguishing the pulses according to their frequencies, their amplitude and the applied voltage phase thanks to a computing means for data calculating, acquiring and representing.

4. An automatic evaluation method under a.c. voltage of the ageing of the insulation-mass of rotating machines under medium high voltage according to claim 1, characterized in that it is performed when the machine is running.

5. An automatic evaluation method under a.c. voltage of the ageing of the insulation-mass according to claim 4, characterized in that it consists in following the evolution of the sinusoidal component, in measuring the frequencies, amplitudes and phases of the non linear component thanks to a measuring chain which comprises an analog to digital converter coupled with a calculator which performs a quick Fourier transform of the signal in the useful frequency band, in measuring the natural frequency and the amplitude of the phase of each pulse in comparison with the voltage applied to one of the phase thanks to the use of several different frequencies bandpass filters which are shaped before being acquired by a digital measuring chain, then in distinguishing the pulses according to their frequeny thanks to a computing means for data calculating, acquiring and representing.

6. An automatic evaluation device under a.c. voltage of insulation-mass of a rotating machine (1) under medium high voltage for using the method according to claims 1 to 3, characterized in that it comprises:
- a medium high voltage a.c. supply (3) with controlled amplitude connected to a current differential transformer (6) having three windings by means of a L decoupling inductance (4) and a C capacity free from partial discharges;
- a source of controlled current (7) compensating for the fundamental sinusoidal component of the current flowing through the insulation-mass connected to the transformer (6),
- a filter network comprising a narrow bands filter (8) matching with the fundamental frequency which allows the compensating current to be determined, a low-pass filter (9) having an amplifier for measuring the non-linear component, and several bandpass filters (10) for discriminating pulses according to their frequency components, such filters network being connected to the differential transformer (6) on the one hand, and to a measuring chain (11) on the other, the latter comprising an analog to digital converter coupled with a calculator (12) which performs a quick Fourier transform of the signal in the useful frequency band coupled with measuring and discriminating means (13) of partial discharges, said measuring chain being checked by computing means (14) for calculating, acquiring and representing measurements.

7. An automatic evalutation device under a.c. voltage of insulation-mass (2) of a rotating machine (1) under medium high voltage for using the method according to any one of claims 1, 4 or 5, characterized in that it comprises:
- three L decoupling inductances (20) and three capacities C (21) free from any partial discharges connected with the source of a.c. current on the one hand, and to a differential intensity transformer (22) having three windings on the other hand, a probe for measuring the applied voltage (29),
- a filter network made of a low-pass filter (22) with an amplifier for measuring non pulsatory current (sinusoidal and non-linear components) and several bandpass filters (24) for distinguishing pulses according to their frequency components; that filters network being connected to an analog to digital differential transformer (26) coupled with a calculator (26) which performs a quick Fourier transform of the signal in the useful frequency band coupled with a measuring and discriminating means (27) of partial discharges, said measuring chain being checked by computing means (28) for calculating, acquiring and representing measurements.
